# EUROPÄISCHE PATENTSCHRIFT

(11) **EP 0 637 398 B1**
(45) Veröffentlichungstag und Bekanntmachung des Hinweises auf die Patenterteilung: **03.07.1996**
(21) Anmeldenummer: 93911506.9
(22) Anmeldetag: 26.04.1993
(51) Int. Cl.: G11B 7/12, G11B 7/00, G11C 13/04, H01J 37/22, G06K 7/10

(54) **EINRICHTUNG ZUR OPTISCHEN ABTASTUNG EINES AUFZEICHNUNGSTRÄGERS, INSBESONDERE EINER PHOSPHORSPEICHERPLATTE**
DEVICE FOR THE OPTICAL SCANNING OF A RECORDING MEDIUM, ESPECIALLY A PHOSPHOR STORAGE PLATE
DISPOSITIF DE BALAYAGE OPTIQUE D'UN SUPPORT D'ENREGISTREMENT, NOTAMMENT D'UNE PLAQUE A MEMOIRE AU PHOSPHORE

(30) Priorität: 24.04.1992 DE 4213556
(43) Veröffentlichungstag der Anmeldung: 08.02.1995
(73) Patentinhaber: Max-Planck-Gesellschaft zur Förderung der Wissenschaften e.V. Berlin, D-80539 München (DE)
(72) Erfinder: SCHRÖDER, Rasmus, D-6900 Heidelberg-Ziegelhausen (DE); BURMESTER, Christoph, D-6900 Heidelberg (DE)
(74) Vertreter: Schütz, Peter, Dipl.-Ing.
(86) Internationale Anmeldenummer: EP9301006
(87) Internationale Veröffentlichungsnummer: WO9322764

(56) Entgegenhaltungen:
- EP-A- 0 168 838
- WO-A-85/01818
- US-A- 4 528 445
- PROCEEDINGS OF THE XITH INT. CONG. ON ELECTRON MICROSCOPY Bd. 1, 7. September 1986, Kyoto, JP seiten 29-34 Mori ET Al. "Imaging Plate- a New Recording Material for Electron Microscopy."

## Beschreibung

Die Erfindung geht aus von einer Einrichtung mit den im Oberbegriff des Anspruchs 1 aufgeführten Merkmalen, die aus einer Veröffentlichung von Mori et al., J. Electron. Microsc. 39; 433-436 (1990) bekannt sind.

Die aus der obengenannten Veröffentlichung bekannte Einrichtung ("IP-Lesegerät") enthält einen He-Ne-Laser zur Erzeugung eines Abtaststrahles, der längs eines Abtaststrahlenganges durch einen teildurchlässigen Spiegel auf einen Umlenkspiegel fällt und dann durch eine Linse auf einen Abtastort fokussiert wird, an dem die Phosphorspeicherplatte durch einen Koordinatentisch vorbeibewegt wird. Der Abtaststrahl erzeugt an der sich am Abtastort befindenden Stelle der Phosphorspeicherplatte eine die gespeicherte Information darstellende Fluoreszenzstrahlung, die nach Kollimierung durch die Fokussierungslinse vom Umlenkspiegel und vom teildurchlässigen Spiegel reflektiert und durch eine zweite Linse in die Öffnung einer Blende fokussiert wird, hinter der ein Fotomultiplier angeordnet ist. Die Blende ist erforderlich, um das Lumineszenzsignal von der Speicherplatte lateral zu diskriminieren. Auf diese Weise wird die Auflösung des Lesesystems erhöht.

Wegen der relativ begrenzten Apertur der Fokussierungslinse und den optischen Verlusten, die durch die Linsen und Spiegel im Strahlengang der Lesestrahlung verursacht werden und schließlich wegen der Blende gelangt nur ein relativ kleiner Teil der Fluoreszenzstrahlung zum Fotomultiplier, so daß das Verhältnis von Nutzsignal zu Störsignal am Ausgang des Fotomultipliers zu wünschen übrig läßt.

Der vorliegenden Erfindung liegt, ausgehend von diesem Stand der Technik, die Aufgabe zugrunde, eine Einrichtung mit den im Oberbegriff des Anspruchs 1 aufgeführten Merkmalen anzugeben, bei der ein wesentlich größerer Teil der vom Abtaststrahl am Abtastort erzeugten Nutzstrahlung durch den Fotodetektor erfaßt werden kann und gleichzeitig eine sehr hohe laterale Ortsauflösung erreicht wird.

Diese Aufgabe wird durch die im Patentanspruch 1 gekennzeichnete Einrichtung gelöst. Weiterbildungen und vorteilhafte Ausgestaltungen dieser erfindungsgemäßen Einrichtung sind Gegenstand von Unteransprüchen.

Die vorliegende Einrichtung zeichnet sich durch ein im wesentlichen konfokales optisches Spiegelsystem sehr hoher Apertur aus, das einen sehr großen Teil der beim Lesen erzeugten Nutzstrahlung erfaßt und praktisch verlustfrei zum Photodetektor weiterleitet. Durch die abbildende Eigenschaft des Spiegelsystems kann die vom Eintrittsfenster des Photodetektors (SEV) oder von einem diesem vorgeschalteten Farbglasfilter zurückgestreute Laserstrahlung in einem als Strahlenfalle ausgelegten weiteren Hohlspiegel, der sich an das eigentliche abbildende Spiegelsystem anschließt, absorbiert werden. Die Empfindlichkeit und das Auflösungsvermögen sind hoch..

Bei einer bevorzugten Einrichtung zum Abfragen der in einer Phosphorspeicherplatte gespeicherten Information wird ein Laserabtaststrahl verwendet, dessen Intensität wesentlich höher ist als die des Laser-Lesestrahles der bekannten Phosphorspeicherplatten-Lesegeräte. Beispielsweise kann ein He-Ne-Laser mit einer Dauerstrichleistung von mehr als 10 mW, insbesondere mehr als 15 mW verwendet werden. Die hohe Leistung ist erst dadurch sinnvoll einsetzbar, daß durch die abbildende Eigenschaft des Spiegelsystems das vom Farbfilter und/oder dem Eintrittsfenster des Photodetektors auf die Speicherplatte zurückgestrahlte Laserlicht sehr stark unterdrückt wird.

Die Einrichtung gemäß der Erfindung eignet sich insbesondere zur optischen Abtastung von Phosphorspeicherplatten und wird daher im folgenden anhand dieser Anwendung erläutert. Die Erfindung ist jedoch nicht auf Lesegeräte für Phosphorspeicherplatten beschränkt, sondern kann auch zum Lesen anderer Aufzeichnungsträger verwendet werden, in denen Information in optisch lesbarer Form gespeichert ist.

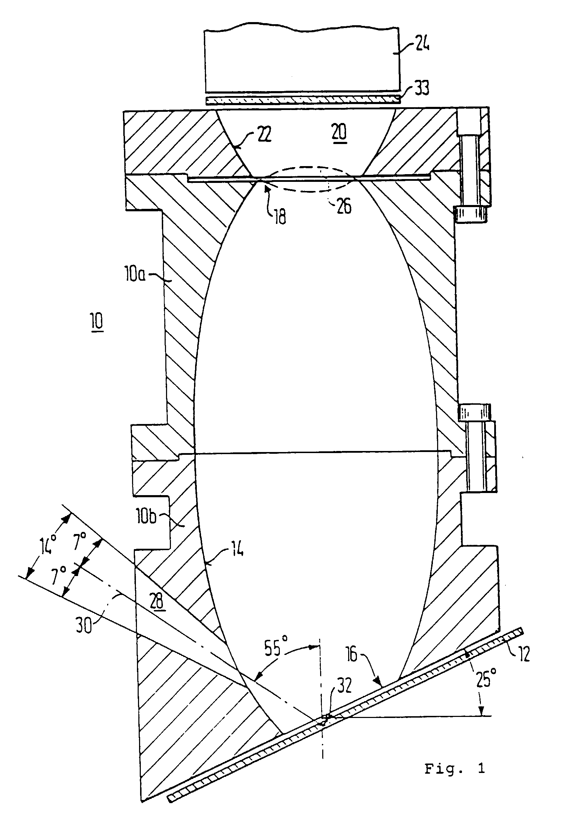

Im folgenden wird die Erfindung anhand eines bevorzugten Ausführungsbeispieles unter Bezugnahme auf die Zeichnung näher erläutert, deren einzige Figur einen Axialschnitt der für die Erfindung wesentlichen Teile einer Einrichtung zur optischen Abtastung einer Phosphorspeicherplatte zeigt.

In der Zeichnung ist im Axialschnitt im wesentlichen das optische System eines Abtastkopfes 10 dargestellt, der zum optischen Abtasten einer Phosphorspeicherplatte 12 dient. Der Abtastkopf 10 ist bezüglich der Speicherplatte 12 verschiebbar, z. B. indem eines der beiden Elemente fest gelagert und das andere mit einem geeigneten Antrieb, wie einem schrittmotorgesteuerten Koordinatenantrieb verbunden ist (nicht dargestellt).

Der Abtastkopf 10 besteht aus zwei miteinander verschraubten hohlen Teilen 10a, 10b und bildet innen einen Hohlraum in Form eines langgestreckten Rotationsellipsoids, das bei dem dargestellten Ausführungsbeispiel eine kleine Halbachse von 20 mm und eine große Halbachse von etwa 48 mm hat. Die Innenwand des Hohlraumes bildet einen ellipsoidförmigen Spiegel 14. Das der Speicherplatte 12 zugewandte Ende des Ellipsoids ist unter einem Winkel von 25 Grad zur langen Achse des Ellipsoids schräg abgeschnitten, um eine Eintrittsöffnung 16 zu bilden, durch die die beim Lesen der Speicherplatte entstehende Nutzstrahlung, also hier Fluoreszenzstrahlung, in den durch den Spiegel 14 begrenzten Hohlraum eintreten kann. Die Speicherplatte 12 ist parallel zur Ebene der Eintrittsöffnung 16 bei dieser gehaltert.

Das obere Ende des Hohlraumes ist gerade abgeschnitten, um eine Austrittsöffnung 18 für die Nutzstrahlung zu bilden. An die Austrittsöffnung 18 schließt sich ein sich erweiternder Hohlraum 20 mit spiegelnder Innenwand 22 an, an dessen der Austrittsöffnung 18 entgegengesetzten Öffnung ein als Fotodetektor dienender Fotomultiplier (SEV) 24 angeordnet ist.

Zwischen der Austrittsöffnung 18 und dem Hohlraum 20 kann eine Blende angeordnet werden, die die Nutzstrahlung, also hier eine blaue Fluoreszenzstrahlung, lateral diskriminiert und somit die Ortsauflösung erhöht. Zwischen dem Photomultiplier 24 und dem Hohlraum 20 ist ein Farbglasfilter 33 angeordnet, das nur Nutzstrahlung, also das blaue Lumineszenzlicht, transmittiert während es die rote Laserstrahlung absorbiert und/oder in den Hohlraum reflektiert. während es die Abtaststrahlung, hier rote Laserstrahlung, sperrt.

Im unteren Teil 10b des Abtastkopfes 10 ist ein sich außen schwach konisch erweiternder Kanal 28 für einen Abtaststrahl 30 vorgesehen. Der Kanal hat hier einen Öffnungswinkel von 14 Grad und der Strahlengang des Abtaststrahls 30 bildet einen Winkel von 55 Grad mit der langen Achse des Ellipsoids, so daß der Abtaststrahl nicht zu schräg auf die Oberfläche der Speicherplatte fällt, die auch aus diesem Grund im Winkel zur Längsachse des Spiegels 14 angeordnet ist.

Die Eintrittsöffnung 16 hatte bei dem dargestellten Ausführungsbeispiel einen Durchmesser von 21 mm, die Austrittsöffnung 18 einen Durchmesser von 16,5 mm, das den Hohlraum 20 bildende Bauteil hatte eine axiale Abmessung von 12 mm und eine dem Fotomultiplier zugewandte Öffnung mit einem Durchmesser von etwa 29,5 mm. Diese und die oben erwähnten Parameter, Maße und Winkel sind selbstverständlich nicht einschränkend auszulegen.

Im Betrieb fällt der von einem nicht dargestellten He-Ne-Laser erzeugte Lese- oder Abtaststrahl 30 an einem Abtastort 32 auf die Phosphorspeicherplatte 12 und läßt dort eine im allgemeinen blaue Fluoreszenzstrahlung entstehen, deren Intensität von der an der betreffenden Stelle gespeicherten Information abhängt. Diese Nutzstrahlung wird wegen der sehr hohen Apertur des Spiegelsystems, die in der Praxis über 0,9 liegt, vom optischen Spiegelsystem im wesentlichen vollständig gesammelt und in die Mitte der Ebene der Austrittsöffnung 18 fokussiert. Unerwünschte Streustrahlung, die durch Streuung des Abtaststrahles in der multikristallinen Phosphorspeicherplatte 12 entsteht, wird durch das Farbfilter 26 absorbiert und/oder durch Mehrfachreflexion im Hohlraum 20 so weit abgeschwächt, daß die Streustrahlung nur noch sehr stark geschwächt in den ellipsoidförmigen Hohlraum gelangt und somit keine Laserintensität außerhalb des Ortes 32 auf die Speicherplatte einwirkt. Dadurch wird nur am Ort 32 ein Nutzsignal, also Fluoreszenzstrahlung, erzeugt wodurch die Auflösung des Lesesystems erhöht wird.

Der beschriebene langgestreckte ellipsoidförmige Spiegel 14 stellt eine optimale Realisierung des hier angewandten konfokalen Spiegelabbildungssystems dar. Da außer dem Farbfilter 26, das in vielen Fällen nicht benötigt wird, und der Lichteintrittsfläche des Fotomultipliers 24 vom Fluoreszenzlicht keine Grenzflächen durchsetzt werden müssen, sind die optischen Verluste minimal.

Anstelle des beschriebenen rotationsellipsoidförmigen Spiegels können jedoch auch andere Spiegelsysteme verwendet werden, z. B. ein Spiegel in Form eines dreiachsigen Ellipsoids, ferner zwei Rotationsparaboloide, die sich mit ihren großen Öffnungen gegenüberstehen oder auch andere Spiegelsysteme, welche wenigstens annähernd eine konfokale Abbildung des Abtastortes 32 in die relativ große Austrittsöffnung 18 bewirken.

Die Innenwand 22 des Hohlraumes 20 kann die Form eines Teiles eines Rotationsellipsoids haben, wesentlich ist jedoch nur, daß sie sich von der Austrittsöffnung 18 aus etwas erweitert. Die axiale Länge des Hohlraumes 20 wird im allgemeinen kleiner als der Durchmesser der Austrittsöffnung 18 sein und dieser wird wiederum im allgemeinen kleiner als der Durchmesser der Eintrittsöffnung 16 sein.

Die Flächen 14 und 22 können durch Drehen mit einem Diamantwerkzeug hergestellt werden.

Da bei dem vorliegenden konfokalen Abbildungssystem trotz seiner sehr hohen Apertur die Rücktstrahlung des Störsignals, hier die in das ellipsoidförmige Spiegelsystem von der Speicherplatte und dem Farbfilter bzw. Multiplier reflektierte Laserstrahlung durch den Hohlraum 20 stark unterdrückt wird, kann man bei der vorliegenden Einrichtung einen Abtaststrahl 30 mit wesentlich höherer Intensität verwenden, als bei den bekannten Einrichtungen der vorliegenden Art. Bei einer praktischen Ausführungsform der Erfindung wurde ein He-Ne-Laserstrahl mit einer Leistung von 16 mW verwendet. Die Erhöhung der Leistung des Abtaststrahls bringt den wesentlichen Vorteil mit sich, daß die Farbzentren beim Abtasten praktisch völlig gelöscht werden, so daß die schon abgetasteten Bereiche der Speicherplatte durch gestreute Abtaststrahlung auch nicht mehr zu einer Störfluoreszenz angeregt werden können, die die Auflösung beeinträchtigen würde.

## Patentansprüche

1. Einrichtung zur optischen Abtastung eines Aufzeichnungsträgers, insbesondere einer Phosphorspeicherplatte mit einem relativ zum Aufzeichnungsträger (12) beweglichen Abtastkopf (10), der einen Abtaststrahlengang, längs dessen ein Abtaststrahl (30) auf einen vorgegebenen Abtastort (32) fällt, an dem der Aufzeichnungsträger durch die Relativbewegung vorbeibewegbar ist, und ein spiegeloptisches Abbildungssystem, das Nutzstrahlung, die durch den Abtaststrahl (30) am Abtastort (32) erzeugt wird, im wesentlichen in eine Bildebene fokussiert, enthält, und mit einem Fotodetektor (24), der im Wege der Nutzstrahlung im Abstand hinter der Bildebene angeordnet ist, **dadurch gekennzeichnet,** daß das Abbildungssystem durch eine spiegelnde Innenfläche (14) eines Hohlraumes gebildet wird, der die Form eines langgestreckten Ellipsoids oder zweier einander gegenüberliegender Paraboloide hat und an axial entgegengesetzten Enden eine Lichteintrittsöffnung (16) bzw. eine Lichtaustrittsöffnung (18) aufweist.

2. Einrichtung nach Anspruch 1, **dadurch gekennzeichnet,** daß der Hohlraum (14) die Form eines Rotationsellipsoids hat.

3. Einrichtung nach Anspruch 1, 2 oder 3, **dadurch gekennzeichnet**, daß die Ebene der Eintrittsöffnung (16) schräg zur Längsachse des Hohlraumes verläuft.

4. Einrichtung nach einem der vorhergehenden Ansprüche, **dadurch gekennzeichnet,** daß der Abtastkopf (10) eine schräg zur Längsachse des Hohlraumes verlaufende Öffnung (28) für den Abtaststrahl (30) aufweist.

5. Einrichtung nach einem der vorhergehenden Ansprüche, **dadurch gekennzeichnet**, daß zwischen der Austrittsöffnung (18) des Hohlraumes (14) und dem Fotodetektor (24) ein sich in Ausbreitungsrichtung der Strahlung erweiternder Hohlraum (20) angeordnet ist.

6. Einrichtung nach Anspruch 5, **dadurch gekennzeichnet,** daß die Wände des Hohlraums im Querschnitt konkav sind.

7. Einrichtung nach Anspruch 5 oder 6, **dadurch gekennzeichnet,** daß die Wand (22) des erweiternden Hohlraums (20) spiegelt.

8. Einrichtung nach einem der vorhergehenden Ansprüche, **dadurch gekennzeichnet,** daß der Abtaststrahlengang (30) schräg zur Längsachse des Spiegelsystems (14) verläuft und daß der Aufzeichnungsträger (12) bezüglich der Längsachse des Spiegelsystems zum Abtaststrahlengang hin geneigt gehaltert ist.

## Claims

1. Device for optically scanning a recording medium, in particular a phosphor storage disc, with a scanning head (10) which is movable relative to the recording medium (12) and which contains a scanning beam path along which a scanning beam (30) strikes a predetermined scanning location (32) past which the recording medium can be moved by the relative movement, and a mirror-optics imaging system which essentially focuses, in an image plane, effective radiation which is produced by the scanning beam (30) at the scanning location (32), and with a photodetector (24) which is arranged in the path of the effective radiation at a distance behind the image plane, characterised in that the imaging system is formed by a reflective inner surface (14) of a cavity which has the form of an elongate ellipsoid or two mutually opposed paraboloids and at axially opposed ends comprises a light input opening (16) or a light output opening (18).

2. Device according to claim 1, characterised in that the cavity (14) has the form of an ellipsoid of revolution.

3. Device according to claim 1, 2 or 3, characterised in that the plane of the input opening (16) extends obliquely to the longitudinal axis of the cavity.

4. Device according to any of the preceding claims, characterised in that the scanning head (10) comprises an opening (28) extending obliquely to the longitudinal axis of the cavity for the scanning beam (30).

5. Device according to any of the preceding claims, characterised in that between the output opening (18) of the cavity (14) and the photodetector (24) is arranged a cavity (20) which widens in the direction of propagation of the radiation.

6. Device according to claim 5, characterised in that the walls of the cavity are concave in cross-section.

7. Device according to claim 5 or 6, characterised in that the wall (22) of the widening cavity (20) is reflective.

8. Device according to any of the preceding claims, characterised in that the scanning beam path (30) extends obliquely to the longitudinal axis of the mirror system (14) and in that the recording medium (12) is mounted inclined towards the scanning beam path relative to the longitudinal axis of the mirror system.

## Revendications

1. Dispositif de balayage optique d'un support d'enregistrement, notamment d'une plaque de stockage mémoire au phosphore, avec une tête de balayage (10) déplaçable par rapport au support d'enregistrement (12), comportant un trajet de rayon de balayage, le long duquel un rayon de balayage (30) tombe sur un site de balayage (32) prédéterminé, sur lequel le support d'enregistrement est déplaçable par le mouvement relatif et comportant un système de représentation à optique et à miroir, qui focalise le rayonnement utile, produit par le rayon de balayage (30) sur le site de balayage (32), sensiblement dans un plan image, et avec un photo-détecteur (24) qui est disposé dans le chemin du rayonnement utile, à distance derrière le plan image, caractérisé en ce que le système de représentation est constitué par une surface intérieure (14) réfléchissante d'un espace creux, qui présente la forme d'une ellipsoïde allongée ou de deux paraboloïdes opposés mutuellement et qui présente aux extrémités axialement opposées une ouverture d'entrée de lumière (16), ou l'ouverture de sortie de lumière (18).

2. - Dispositif selon la revendication 1, caractérisé en ce que l'espace creux (14) à la forme d'une ellipsoïde de rotation.

3. - Dispositif selon la revendication 1, 2 ou 3, caractérisé en ce que le plan de l'ouverture d'entrée (16) court obliquement par rapport à l'axe longitudinal de l'espace creux.

4. - Dispositif selon l'une des revendications précédentes, caractérisé en ce que la tête de balayage (10) présente une ouverture (28) courant obliquement par rapport à l'axe longitudinal de l'espace creux et destinée au rayon de balayage (30).

5. - Dispositif selon l'une des revendications précédentes, caractérisé en ce qu'entre l'ouverture de sortie (18) de l'espace creux (14) et le photo-détecteur (24) est disposé un espace creux allant en s'agrandissant dans la direction de propagation du rayon.

6. - Dispositif selon la revendication 5, caractérisé en ce que les parois de l'espace creux ont une allure concave lorsqu'on les observe en section transversale.

7. - Dispositif selon la revendication 5 ou la revendication 6, caractérisé en ce que la paroi (21) de l'espace creux (20) allant en s'agrandissant est réfléchissante.

8. - Dispositif selon l'une des revendications précédentes, caractérisé en ce que le trajet (30) du rayon de balayage court obliquement par rapport à l'axe longitudinal du système réfléchissant (14) et en ce que le support d'enregistrement (12) est maintenu incliné par rapport à l'axe longitudinal du système réfléchissant, au point de passage du trajet du rayon de balayage.
